(19) Europäisches Patentamt / European Patent Office / Office européen des brevets

(11) **EP 2 485 249 B1**

(12) **FASCICULE DE BREVET EUROPEEN**

(45) Date de publication et mention
de la délivrance du brevet:
**16.05.2018   Bulletin 2018/20**

(51) Int Cl.:
*H01L 21/268* (2006.01)          *H01L 21/302* (2006.01)
*H01L 21/324* (2006.01)          *H01L 21/762* (2006.01)

(21) Numéro de dépôt: **12153906.8**

(22) Date de dépôt: **03.02.2012**

(54) **Procédé de lissage de la surface d'une plaque semiconductrice**

Verfahren zum Glätten der Oberfläche eines Halbleiterwafers

Method of smoothing the surface of a semiconductor wafer

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité:  **04.02.2011  FR 1150935**

(43) Date de publication de la demande:
**08.08.2012  Bulletin 2012/32**

(73) Titulaire: **Soitec**
**38190 Bernin (FR)**

(72) Inventeur: **Bruel, Michel**
**38113 VEUREY-VOROIZE (FR)**

(74) Mandataire: **Regimbeau**
**20, rue de Chazelles**
**75847 Paris Cedex 17 (FR)**

(56) Documents cités:
**EP-A1- 1 158 581     WO-A2-2007/142911**

**Description**

**DOMAINE DE L'INVENTION**

La présente invention concerne un procédé de lissage de la surface d'une plaque semiconductrice.

Les plaques semiconductrices concernées par l'invention peuvent, de manière non limitative, être de type SOI (Silicon On Insulator selon la terminologie anglo-saxonne répandue, pour Silicium sur Isolant). On précise que le terme SOI recouvre dans ce texte tout type de plaque ou, plus généralement substrat, comprenant une couche utile dans laquelle on pourra constituer des composants par exemple électroniques, une couche de support et une couche électriquement isolante entre la couche utile et la couche de support.

**ARRIERE PLAN DE L'INVENTION**

Les plaques semiconductrices sont utilisées dans des applications telles que l'électronique ou l'optronique par exemple, notamment pour constituer sur de telles structures des composants et circuits. Ces plaques (ou wafers) peuvent être circulaires, d'un diamètre par exemple de 200, 300 ou 450 mm. Mais il peut s'agir également de substrats de dimensions et de formes autres, comme par exemple des panneaux rectangulaires pour des applications dans le domaine du photovoltaïque ou de l'affichage (écran)

La qualité de surface de ces plaques est un paramètre important. Cette qualité de surface est caractérisée notamment par une mesure de rugosité, qui doit être la plus faible possible. La rugosité peut être mesurée à différente fréquences, la rugosité haute fréquence caractérisant des variations de haute fréquence spatiale d'état de surface de la plaque alors que la rugosité basse fréquence caractérise des variations de plus basses fréquences spatiales.

Afin d'améliorer cette qualité de surface plusieurs types de technique ont été envisagées: planarisation par des moyens mécaniques ou chimiques (éventuellement combinés), recuit thermique (notamment à des températures élevées), etc. Il a également été proposé d'exposer la surface des plaques à des pulsations d'une radiation issue d'un laser ou d'une source micro-ondes. On pourra à cet égard se référer par exemple au document WO 2007/142911. Ce document propose d'appliquer à la surface d'un substrat un flux pulsé. Il ne divulgue ni ne suggère l'utilisation d'une longueur de référence pour dimensionner le flux appliqué sur la surface.

Un objectif principal de l'invention est de proposer une amélioration pratique des techniques de diminution de rugosité des plaques semiconductrices.

**BREVE DESCRIPTION DE L'INVENTION**

Conformément à l'invention, il est proposé un procédé de lissage de la surface d'une plaque semiconductrice, comprenant la mise en fusion de ladite surface par balayage de ladite surface par un faisceau de fusion, caractérisé en ce qu'il comprend :

- La définition d'une longueur de référence,
- Le réglage des paramètres du faisceau de fusion de manière à fusionner, lors du balayage de la surface, une zone locale de surface de la plaque dont la longueur est supérieure ou égale à la longueur de référence,
- La fusion ainsi réalisée permettant de lisser ladite surface de manière à éliminer les rugosités de surface de période inférieures à la longueur de référence.

Selon d'autres caractéristiques avantageuses et non limitatives :

- la définition de la longueur de référence fait suite à une observation de la distribution de rugosité de la surface de la plaque et à l'identification d'une fréquence de coupure issue de la distribution des fréquences de rugosité observées à la surface de la plaque ;
- la définition de la longueur de référence fait suite à la détermination d'une dimension de référence représentative de dispositifs devant être constitués dans une région de surface de la plaque, la longueur de référence étant supérieure ou égale à la dimension de référence ;
- la mise en fusion comprend la fusion de la zone locale de la plaque et le faisceau de fusion est un faisceau énergétique apte à faire fondre une région de surface de la plaque ;
- la mise en fusion comprend l'apport de matériau fondu sur ladite zone locale de la plaque et le faisceau de fusion est défini par la section du flux d'apport de matériau fondu à la surface de la plaque ;
- lesdits paramètres du faisceau de fusion comprennent la vitesse de déplacement du faisceau ;
- lesdits paramètres du faisceau de fusion comprennent la densité de puissance du faisceau ;
- lesdits paramètres du faisceau de fusion comprennent le débit du flux d'apport de matériau fondu.

## BREVE DESCRIPTION DES DESSINS

D'autres caractéristiques et avantages de l'invention ressortiront de la description détaillée qui va suivre, en référence aux dessins annexés sur lesquels :

- la figure 1 est une représentation schématique d'une distribution de spectre de rugosité pouvant être observé sur une plaque, avant son traitement selon l'invention. Cette figure fait apparaître une fréquence spatiale de coupure, au-delà de laquelle on désire réduire fortement voire éliminer la rugosité,
- la figure 2 est une représentation schématique illustrant le principe de lissage mis en oeuvre dans l'invention, faisant notamment apparaître une zone localisée fondue par irradiation (figure 2b), ladite zone étant de longueur contrôlée comme cela sera expliqué. Cette figure fait apparaître en élévation une plaque avant son lissage (figure 2a), et pendant son lissage (figure 2b),
- la figure 3 est une représentation de cette zone localisée, illustrant différents paramètres influant sur la définition de cette zone,
- la figure 4 montre deux vues analogues à celles des figures 2a et 2b (figures 4a et 4b, respectivement), en illustration d'un mode de réalisation de l'invention dans lequel on apporte à la surface de la plaque à lisser du matériau fondu,
- les figures 5a et 5b illustrent l'évolution d'une surface traitée pendant un intervalle de temps dt, dans le cas d'un traitement continu (mettant en oeuvre un balayage de la surface à traiter par un faisceau de fusion se déplaçant de manière continue),
- la figure 5c représente une fonction dite alpha par un tel traitement continu,
- la figure 5d représente les densités spectrales de fréquences de rugosité observées à la surface d'une plaque, sans traitement et avec un puis deux traitements continus, à partir d'un spectre quelconque de rugosité initial,
- la figure 5e représente les densités spectrales de fréquences de rugosité observées à la surface d'une plaque, sans traitement et avec un puis deux traitements continus, à partir d'un spectre blanc de rugosité initial,
- la figure 6a illustre l'évolution d'une surface traitée pendant un intervalle de temps dt, dans le cas d'un traitement fractionné (mettant en oeuvre un balayage de la surface à traiter par un faisceau de fusion se déplaçant pas à pas),
- la figure 6b représente les densités spectrales de fréquences de rugosité observées à la surface d'une plaque, sans traitement et avec un traitement fractionné, à partir d'un spectre quelconque de rugosité initial,
- la figure 6c représente les densités spectrales de fréquences de rugosité observées à la surface d'une plaque, sans traitement et avec un traitement fractionné, à partir d'un spectre blanc de rugosité initial,
- la figure 7a représente les densités spectrales de fréquences de rugosité observées à la surface d'une plaque, sans traitement, avec un traitement continu et avec un traitement fractionné, à partir d'un spectre quelconque de rugosité initial,
- la figure 7b représente les densités spectrales de fréquences de rugosité observées à la surface d'une plaque, sans traitement, avec un traitement continu et avec un traitement fractionné, à partir d'un spectre blanc de rugosité initial.

## DESCRIPTION DETAILLEE DE L'INVENTION

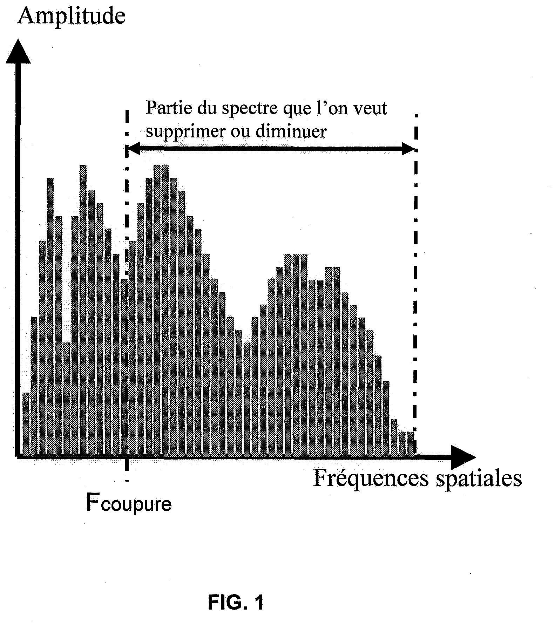

La figure 1 est une représentation schématique d'une distribution de spectre de rugosité pouvant être observé sur une plaque semiconductrice, avant son traitement selon l'invention. La plaque peut avoir été obtenue par transfert de couche (par exemple par un procédé de type Smart-Cut) ou par un autre moyen. La surface de la plaque peut être par exemple en silicium.

Sur ce graphe, l'amplitude correspond à une intensité de la rugosité en fonction des fréquences spatiales.

Le graphe de la figure 1 fait apparaître une fréquence spatiale de coupure Fcoupure, au-delà de laquelle on désire réduire fortement voire éliminer la rugosité. En d'autres termes cette fréquence de coupure correspond en termes de périodes spatiales à une longueur en-dessous de laquelle on désire réduire fortement voire éliminer la rugosité sur la surface de la plaque.

Pour cela on va commencer par définir une longueur de référence qui va dimensionner le traitement de lissage devant être appliqué à la surface de la plaque.

Cette longueur de référence peut être égale à la période correspondant à Fcoupure (c'est-à-dire égale à $2\pi$/Fcoupure). Alternativement la longueur de référence peut être liée à la période correspondant à Fcoupure par toute relation déterminée, par exemple une relation de proportionnalité donnée (dans ce dernier cas la longueur de référence est égale à la période correspondant à Fcoupure, multipliée par un facteur déterminé). Il est également possible de définir la longueur de référence indépendamment de la rugosité observée à la surface de la plaque.

Une fois la longueur de référence définie on va appliquer à la surface de la plaque un traitement de lissage qui comprend la mise en fusion de ladite surface par balayage de ladite surface par un faisceau de fusion.

Par « mise en fusion » on entend toute étape conduisant à l'obtention à la surface de la plaque d'un état fondu du matériau, permettant au dit matériau de se répandre de manière homogène et sensiblement plane. La mise en fusion peut ainsi être obtenue par la mise en oeuvre de deux configurations principales, éventuellement combinées :

- l'application d'un faisceau (continu ou non) d'énergie de manière à faire fondre le matériau de la surface de la plaque, et/ou
- l'apport d'un flux (continu ou non) de matériau fondu à la surface de la plaque.

Par convention on définit dans ce texte :

- le « vecteur d'apport de fusion » comme le faisceau d'énergie permettant de faire fondre le matériau de la surface de la plaque, et/ou le flux d'apport de matériau fondu, selon la configuration applicable,
- Le « faisceau de fusion » comme la portion d'espace délimitant le vecteur d'apport de fusion,
- La « zone fondue » comme la zone de la surface de la plaque qui se trouve dans un état fondu suite à l'application du vecteur d'apport de fusion sur cette surface.

Dans le cas d'un apport d'énergie seul, le vecteur d'apport de fusion est un faisceau énergétique (par exemple un faisceau lumineux issu d'une source telle qu'un laser, ou toute autre source d'énergie apte à faire fondre la surface de la plaque tel que des faisceaux de particules énergétiques électrons ou ions notamment).

Dans le cas d'un apport de matériau fondu seul, le vecteur d'apport de fusion est un flux d'apport de matériau (par exemple du silicium) fondu à la surface de la plaque. Le faisceau de fusion est alors défini par la section du flux d'apport de matériau fondu à la surface de la plaque.

Dans tous les cas, le faisceau de fusion définit à la surface de la plaque une longueur d'application. Cette longueur d'application est à chaque instant la longueur de la zone de la surface de la plaque qui se trouve dans un état fondu du fait de l'application du faisceau de fusion (on appelle cette zone « zone fondue »).

Dans le cas d'un faisceau de fusion se déplaçant de manière continue à la surface de la plaque, cette zone fondue se déplace également continûment. Dans le cas d'un faisceau appliqué de manière stationnaire en une succession d'endroits de la surface de la plaque et déplacé pas à pas la zone fondue se déplace de manière fractionnée, pas à pas.

Dans le cas d'un déplacement continu du faisceau de fusion la zone fondue s'étend à la surface de la plaque en regard du faisceau de fusion et également en arrière de la région d'application du faisceau sur le surface de la plaque, cet arrière étant défini par rapport à l'avancement du faisceau par rapport à la plaque.

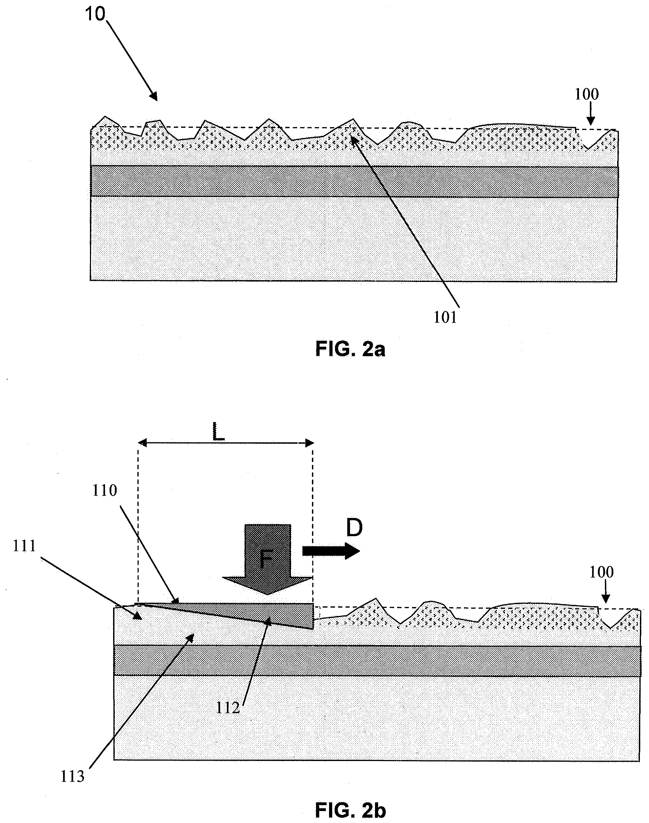

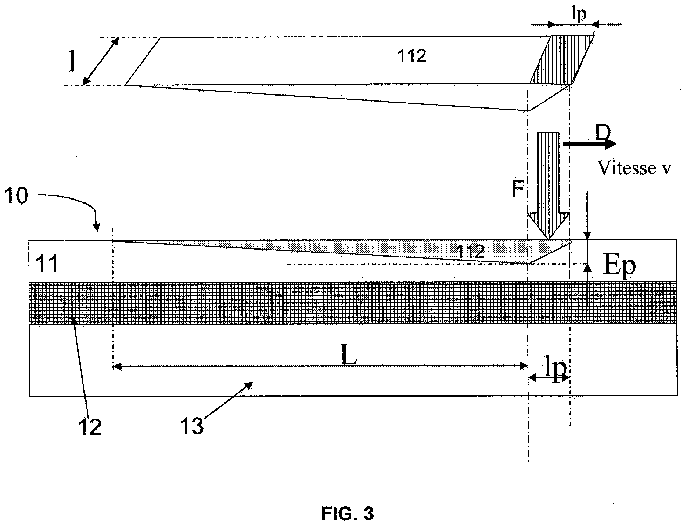

La zone fondue s'étend ainsi, selon la direction d'avancement du faisceau (direction D sur la figure 2b), sur une longueur L (voir figures 2b et 3). Si la vitesse de déplacement du faisceau de fusion est constante (et que les autres paramètres du faisceau de fusion ne changent pas non plus) la longueur L est également constante.

Comme illustré sur la figure 2b, il est important de contrôler les paramètres du faisceau de fusion de manière à préserver une partie de l'épaisseur de la couche traitée « non fondue » afin de permettre la restauration, après refroidissement, de la qualité cristalline de la couche traitée.

L'épaisseur de la couche de surface qui est fondue est choisie de telle sorte que l'épaisseur restante non fondue soit suffisante pour que lors de la phase de refroidissement-recristallisation cette dite épaisseur restante puisse jouer correctement le rôle de germe (template en anglais) pour que la recristallisation de la couche fondue procède par épitaxie sur ce dit germe. Par exemple une épaisseur restante non fondue représentant de 25% à 50% de l'épaisseur d'une couche d'épaisseur 200 nm pourrait convenir. Ceci est obtenu par le contrôle des caractéristiques de l'apport de fusion et du faisceau de fusion.

On conserve ainsi, dans la couche de surface et sous la région fondue, une région non fondue - qui donnera pendant le refroidissement ultérieur l'empreinte cristalline pour une recristallisation épitaxiale si cela est désiré.

La figure 2a montre un plan 100 qui correspond au plan moyen de la surface perturbée de la plaque 10. La surface 101 de matériau perturbé s'étend de part et d'autre de ce plan moyen.

La figure 2b montre la surface lissée 110 sous le faisceau de fusion et en arrière de lui. Cette surface lissée s'inscrit dans le plan 100. La figure montre également le matériau restoré 111, suite à l'application du faisceau de fusion. On voit la zone 112 fondue localement par le faisceau de fusion ainsi que la région 113 de matériau non fondu..

L'invention met comme on l'a dit en oeuvre la définition d'une longueur de référence.

Elle met également en oeuvre le réglage des paramètres du faisceau de fusion de manière à fusionner, lors du balayage de la surface de la plaque, une zone locale de surface de la plaque dont la longueur est supérieure ou égale à la longueur de référence. En d'autres termes on contrôle dans le cas de l'invention les paramètres du faisceau de manière à ce que la longueur L soit supérieure ou égale à la longueur de référence.

Ceci permet de fusionner - et donc d'aplanir - le matériau de la surface de la plaque sur une longueur au moins égale à la longueur de référence que l'on a préalablement définie. De la sorte on réalise un aplanissement particulièrement abouti de la surface de la plaque.

La fusion ainsi réalisée permet en effet de lisser la surface de manière à éliminer pratiquement toutes les rugosités de surface de fréquence supérieure (de période inférieure) à celle correspondant à la longueur de référence.

Comme cela a déjà été mentionné le contrôle des paramètres du faisceau permet également d'assurer que l'on fond la couche de surface sur une partie de son épaisseur seulement.

La longueur de référence peut comme cela a déjà été évoqué avoir été définie à partir de mesures de rugosités préalables de la plaque. Dans ce cas la définition de la longueur de référence fait suite à une observation de la distribution de rugosité de la surface de la plaque et à l'identification d'une fréquence de coupure issue de la distribution des fréquences de rugosité observées à la surface de la plaque.

La longueur de référence peut également avoir été définie de manière analogue, à partir de mesures de rugosité d'une ou plusieurs plaque(s) d'un même lot ayant subi des conditions de traitement identiques à la plaque que l'on désire traiter. Elle peut aussi avoir été définie à partir d'un spectre de rugosité enregistré à l'avance et correspondant à la plaque.

La longueur de référence peut également avoir été définie en prenant en compte d'autres considérations, par exemple la taille de composants que l'on désirera réaliser ultérieurement sur la plaque (la longueur de référence peut alors être choisie comme la plus grande longueur des composants).

Dans tous les cas, dans un mode de réalisation préféré la longueur de référence est constante lors de l'application du faisceau de fusion.

On peut envisager de contrôler différents paramètres pour régler le faisceau de fusion.

Il est ainsi possible de régler la vitesse de déplacement du faisceau de fusion. Cette vitesse contribue en effet à déterminer la longueur L de la zone fondue.

Dans le cas d'un apport de fusion par un faisceau énergétique on peut également contrôler la densité d'énergie du faisceau. Ce paramètre contribue en effet à déterminer les caractéristiques de la zone de fusion et notamment sa longueur L.

Dans le cas d'un apport de fusion par un apport d'un flux de matériau fondu on peut également contrôler le débit du flux d'apport de matériau. Ce paramètre contribue en effet dans ce cas à déterminer les caractéristiques de la zone de fusion et notamment sa longueur L.

La plaque semiconductrice ainsi traitée comprend une couche de surface en un matériau semiconducteur dont la surface ne présente pas de rugosité significative de période inférieure à la longueur de référence.

La figure 3 illustre la zone localisée de la plaque qui se trouve en fusion suite à l'application du faisceau de fusion F. Cette figure illustre différents paramètres influant sur la définition de cette zone.

Cette figure illustre l'application du faisceau de fusion à la surface d'une plaque 10 comprenant une couche de surface 11, par exemple en silicium, un substrat support 13 (qui peut être en silicium également) et une couche d'oxyde enterrée 12. La plaque 10 est dans ce cas du type SOI.

La figure 3 fait apparaître la largeur l du faisceau de fusion, qui est finie. On procède donc à des passages successifs du faisceau, sur des traits parallèles qui traversent la surface de la plaque de part en part. Ces passages successifs permettent de couvrir la totalité de la surface de la plaque avec le faisceau et ainsi de traiter cette surface entière.

Il est également possible de prévoir un faisceau dont la largeur l est supérieure à la dimension de la plaque, de manière à traiter la totalité de la plaque avec un seul passage du faisceau.

On peut également prévoir, en variante, de réaliser deux couvertures successives de la totalité de la plaque, chacune des deux couvertures impliquant un ou plusieurs passages du faisceau selon une première et une deuxième directions, respectivement. Les première et deuxième directions peuvent être orthogonales.

Sur la figure 3 le front entre liquide et solide, situé à l'avant de la zone fondue, est représenté comme un triangle dont le sommet correspond à l'arrière du faisceau de fusion. Il s'agit d'une approximation schématique car en réalité les côtés du triangle ne sont pas strictement droits mais présentent une forme incurvée dépendant des conditions choisies. Par ailleurs il est possible que le sommet du triangle soit décalé vers l'arrière, si par exemple la phase liquide de la surface a été chauffée de manière particulièrement importante pendant le passage du faisceau.

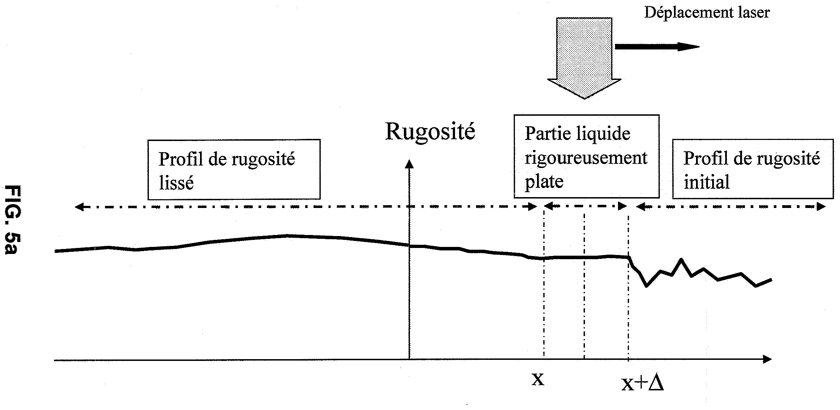

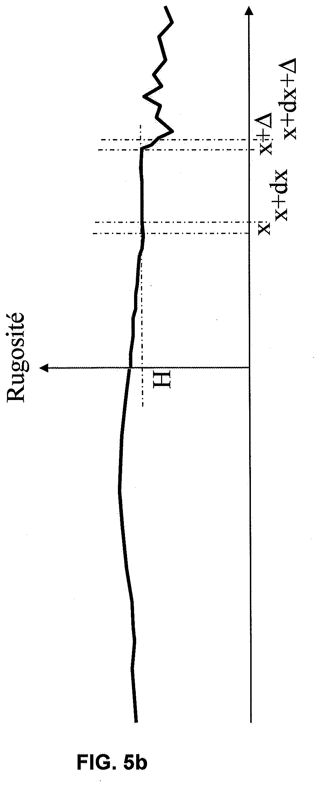

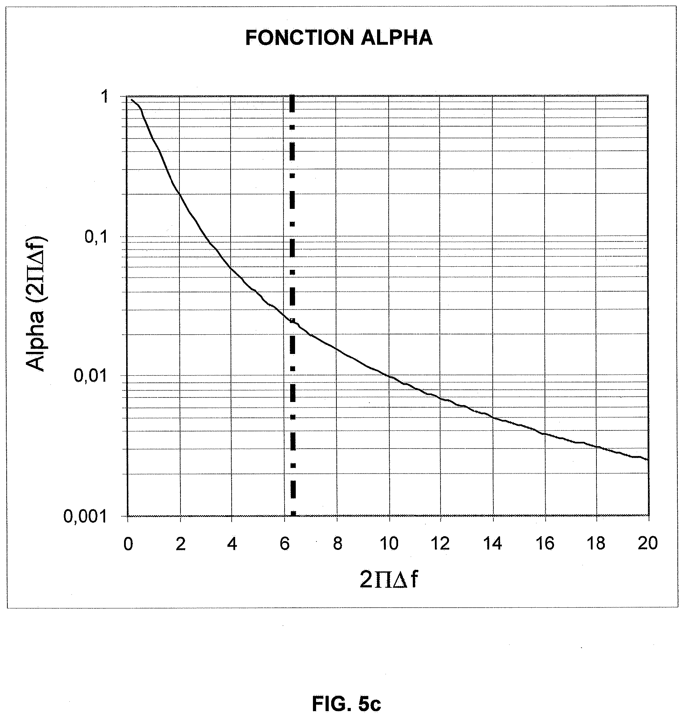

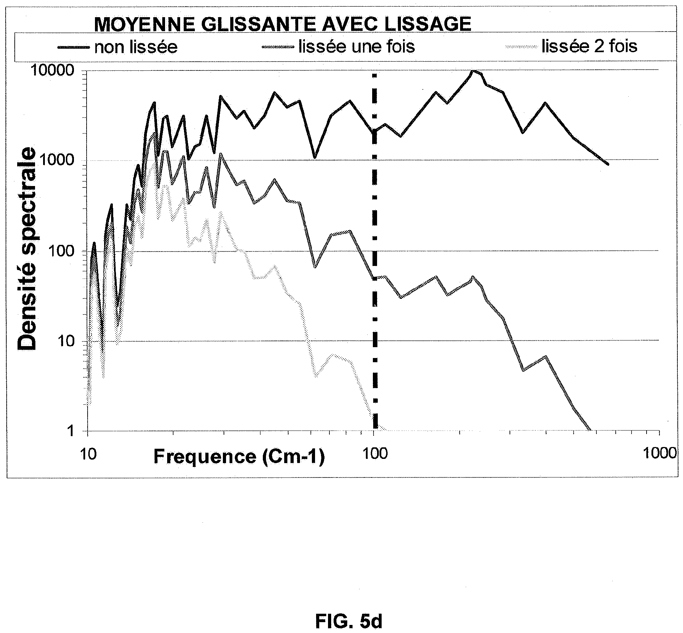

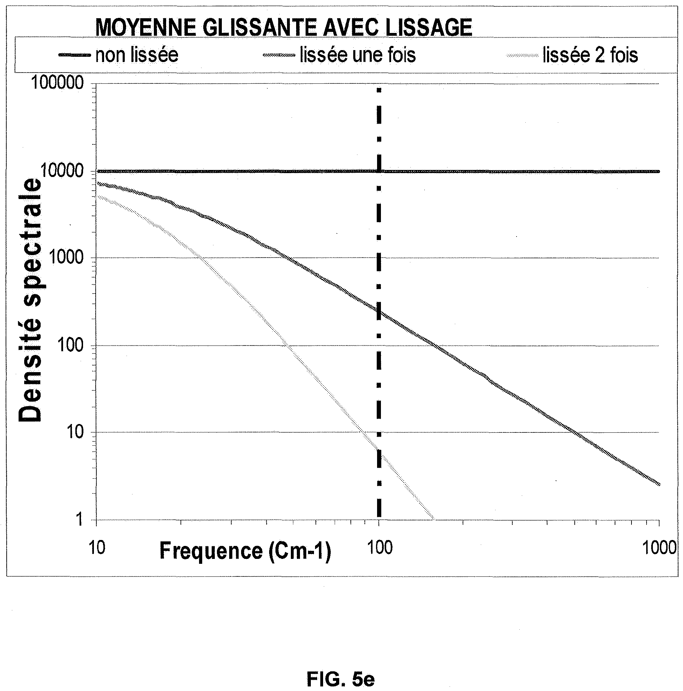

Sur la figure 3 l'épaisseur de la couche 12 d'oxyde enterré est par exemple de 1.5 microns, valeur qui est cohérente avec les exemples numériques qui seront développés plus loin dans ce texte en référence aux figures 5 à 7. On note que le temps de recristallisation du matériau après fusion dépendant au premier ordre de la capacité pour la chaleur de s'évacuer vers la masse du substrat, l'épaisseur de la couche d'oxyde enterrée (qui est un isolant thermique) joue un rôle important.

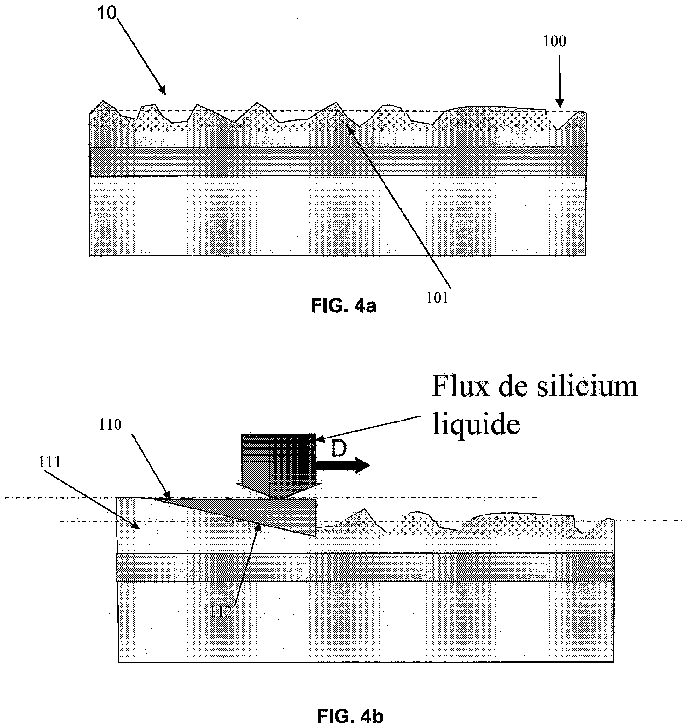

La figure 4 montre deux vues analogues à celles des figures 2a et 2b (figures 4a et 4b, respectivement), en illustration d'un mode de réalisation de l'invention dans lequel on apporte à la surface de la plaque à lisser du matériau fondu.

Le matériau fondu est de même nature que (voire identique à) le matériau de la surface de la plaque (du silicium dans le cas, représenté sur la figure 4, d'un SOI dont la couche superficielle est en silicium).

On constate que dans ce cas non seulement on lisse la surface de la plaque mais on élève également légèrement son niveau, du fait de l'apport de matériau fondu.

Dans toutes les variantes de l'invention la plaque obtenue a après traitement une rugosité de surface dont les composantes de fréquence supérieure à une fréquence de coupure désirée ont été éliminées, ce qui constitue un résultat remarquable.

On va maintenant exposer en référence aux figures 5 à 7 certaines considérations relatives à deux modes de mise en oeuvre de l'invention : par balayage continu de la surface de la plaque par le faisceau de fusion, et par balayage fractionné pas à pas.

Ces considérations sont faites à propos d'une rugosité modélisée par une fonction s(x) qui est la rugosité de surface (variation d'altitude de la surface) en fonction de l'abscisse x à la surface d'une plaque. La fonction s(x) est considérée comme intégrable, puisque la rugosité est limitée en amplitude et que la dimension de la plaquette est finie. Par souci de simplification la fonction s(x) est également supposée paire ; de la sorte la transformées de Fourier S(f) de s(x) est une fonction réelle (partie imaginaire=0).

Les considérations qui vont suivre sont fondées sur des modélisations mathématiques qui fournissent une image approchée de la réalité. Certaines approximations de second ordre ont été faites pour réaliser et exploiter ces calculs qui représentent ainsi un modèle simplifié permettant de mettre en évidence des résultats différents pour le traitement continu et le traitement fractionné.

On a ainsi considéré dans les analyses de Fourier que la phase fondue est parfaitement plane. En pratique cela ne sera pas toujours parfaitement le cas à tout moment, à cause de la tension de surface du matériau fondu et des aspects transitoires et dynamiques dans la phase liquide (ondes, micro-vagues potentielles etc.. ) .

Les figures 5a et 5b illustrent l'évolution d'une surface traitée pendant un intervalle de temps dt, dans le cas d'un traitement continu (c'est-à-dire mettant en oeuvre un balayage de la surface à traiter par un faisceau de fusion se déplaçant de manière continue).

s(x) est le profil de rugosité initial, $\bar{s}(x)$ est le profil de rugosité lissé.

Quand x augmente de dx, H varie de dH, alors :

$$dH = d\bar{s}(x)$$

$$dH = (s(x + \Delta)dx - \bar{s}(x)dx) / \Delta$$

$$D'o\grave{u} : d\bar{s}(x) / dx = (s(x + \Delta) - \bar{s}(x)) / \Delta$$

L'analyse de Fourier de ce signal donne les résultats suivants.

$$i\omega.\overline{S}(\omega) = (\exp(i\omega\Delta) \cdot S(\omega) - \overline{S}(\omega)) / \Delta$$

$$\overline{S}(\omega) \cdot (i\omega + 1/\Delta) = (\exp(i\omega\Delta) \cdot S(\omega)) / \Delta$$

$$\overline{S}(\omega) = S(\omega) \cdot (\exp(i\omega\Delta)) / (i\omega\Delta + 1)$$

$$Appelons \ F(\omega) = \exp(i\omega\Delta) / (i\omega\Delta + 1)$$

$$\overline{S}(\omega) = S(\omega) \cdot F(\omega)$$

$\overline{D}(\omega)$, la densité spectrale énergétique de $\overline{S}(\omega)$, est donnée par :

$$\overline{D}(\omega) = \overline{S}(\omega) \cdot \overline{S}^*(\omega) = S(\omega) \cdot F(\omega) \cdot S^*(\omega) \cdot F^*(\omega)$$

$$\overline{D}(\omega) = S(\omega) \cdot S^*(\omega).F(\omega) \cdot F^*(\omega) = D(\omega) \cdot F(\omega) \cdot F^*(\omega)$$

Où $D(\omega)$ est la densité spectrale énergétique du signal non lissé.

$$F(\omega) \cdot F^*(\omega) = (\exp(i\omega\Delta)/(i\omega\Delta + 1)) \cdot (\exp(-i\omega\Delta)/(-i\omega\Delta + 1))$$

$$F(\omega) \cdot F^*(\omega) = 1/(1 + \Delta^2\omega^2)$$

$$D'où : \overline{D}(\omega) = D(\omega)/(1 + \Delta^2\omega^2)$$

$$Soit : \overline{D}(f) = D(f)/(1 + 4\Pi^2\Delta^2 f^2) = D(f) \cdot \alpha(2\Pi\Delta f)$$

la figure 5c représente ainsi une fonction dite alpha, $\alpha(2\Pi\Delta f) = 1/(1 + 4\Pi^2\Delta^2 f^2)$, qui est la fonction de transfert permettant de passer de la densité spectrale de la rugosité avant le traitement à la densité spectrale de la rugosité après un tel traitement continu. On observe que les valeurs de cette fonction décroissent rapidement. Sur cette figure une valeur de coupure est représentée par un axe pointillé vertical.

La figure 5d représente les densités spectrales de fréquences de rugosité observées à la surface d'une plaque, sans traitement et avec un puis deux traitements continus, à partir d'un spectre quelconque de rugosité initial.

On observe sur cette figure une diminution sensible de la rugosité après un traitement, et une diminution encore plus prononcée après un deuxième traitement. Après ce deuxième traitement on n'observe pratiquement plus de rugosités de fréquence supérieures à 100 cm$^{-1}$.

La figure 5e représente les densités spectrales de fréquences de rugosité observées à la surface d'une plaque, sans traitement et avec un puis deux traitements continus, cette fois à partir d'un spectre blanc de rugosité initial.

On observe ici encore des diminutions sensibles. On remarque que la diminution de rugosité est légèrement moins importante que dans le cas de la figure 5d.

De manière générale les figures 5c à 5e montrent que l'effet du lissage moyennant glissant sur le spectre de rugosité :

- Est indépendant du sens de balayage (gauche droite ou droite gauche),
- Bien que très significatif, il ne permet pas d'éliminer totalement les fréquences supérieures à la fréquence de coupure,
- Un deuxième passage ne laisse pratiquement aucune rugosité dans cette gamme de fréquences,
- Il atténue significativement aussi les fréquences plus basses que la fréquence de coupure, ce qui est aussi un résultat très intéressant.

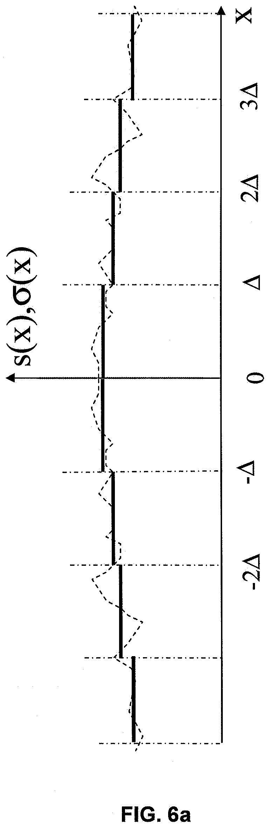

La figure 6a illustre l'évolution d'une surface traitée pendant un intervalle de temps dt, dans le cas d'un traitement fractionné (mettant en oeuvre un balayage de la surface à traiter par un faisceau de fusion se déplaçant pas à pas).

L'analyse de Fourier de la fonction s(x) est réalisée sur les bases suivantes :

- Soit S(f) le spectre de fréquences de la rugosité de surface s(x),
- Soit D la longueur de chaque spot (chaque endroit de la surface de la plaque sur lequel le faisceau va être arrêté),
- La courbe s(x) est transformée par le traitement spot par spot en une courbe $\sigma(X)$ constituée d'une suite de parties plates de longueur $\Delta$, de hauteur si, comprises entre les abscisses $(i-1)\Delta$ et $i\Delta$,
- A la courbe réelle paire $\sigma(X)$ correspond un spectre de fréquences $\Sigma(f)$ qui va être calculé.

Les si sont calculés comme suit :

$$si = (1/\Delta) \times \int_{(i-1)\Delta}^{i\Delta} s(x)dx$$

$$si = (1/\Delta) \times \int_{(i-1)\Delta}^{i\Delta} dx \int_{-\infty}^{+\infty} S(\omega) \cdot \exp(i\omega x)d\omega$$

On change l'ordre d'intégration:

$$si = (1/\Delta) \times \int\limits_{-\infty}^{+\infty} d\omega \int\limits_{(i-1)\Delta}^{i\Delta} S(\omega) \cdot \exp(i\omega x) dx$$

Comme $S(\omega)$ est réelle,

$$si = (1/\Delta) \times \int\limits_{-\infty}^{+\infty} d\omega \int\limits_{(i-1)\Delta}^{i\Delta} S(\omega) \cdot \cos(\omega x) dx = (1/\Delta) \times \int\limits_{-\infty}^{+\infty} S(\omega) d\omega \int\limits_{(i-1)\Delta}^{i\Delta} \cos(\omega x) dx$$

$$D'où\ si = (1/\Delta) \times \int\limits_{-\infty}^{+\infty} S(\omega) \cdot (\sin(i\omega\Delta) - \sin((i-1)\omega\Delta)) d\omega / \omega$$

$$si = (2/\Delta) \times \int\limits_{-\infty}^{+\infty} S(\omega) \cdot \cos((i+1/2)\omega\Delta) \cdot \sin(\omega\Delta/2)) d\omega / \omega$$

On calcule $\Sigma(\omega)$ la transformée de Fourier de $\sigma(X)$, en utilisant les étapes générales suivantes (données à titre d'exemple pour le calcul de la transformée d'une fonction ei(x)).

$$e_i(x) = e_{i+}(x) + e_{i-}(x)$$

$$e_{i+}(x) = Ech(x - \Delta(i-1)) - Ech(x - i\Delta)$$

$$e_{i-}(x) = -Ech(x + \Delta(i-1)) + Ech(x + i\Delta)$$

*D'où transformée de Laplace :*

$$E_{i+}(p) = (1/p)\exp(-\Delta(i-1)p) - (1/p)\exp(-i\Delta p)$$

$$E_{i-}(p) = -(1/p)\exp(+\Delta(i-1)p) + (1/p)\exp(+i\Delta p)$$

$$E_i(p) = (1/p)(\exp(-\Delta(i-1)p) - \exp(+\Delta(i-1)p) + \exp(i\Delta p) - \exp(-i\Delta p))$$

*D'où transformée de Fourier :*

$$E_i(j\omega) = (1/j\omega)(\exp(-\Delta(i-1)j\omega) - \exp(+\Delta(i-1)j\omega) + \exp(i\Delta j\omega) - \exp(-i\Delta j\omega))$$

$$E_i(j\omega) = (2/j\omega)(-j\sin(\Delta(i-1)\omega) + j\sin(i\Delta\omega))$$

$$E_i(j\omega) = (-2/\omega)(\sin(\Delta(i-1)\omega) - \sin(i\Delta\omega))$$

$$E_i(j\omega) = (4/\omega)(\cos(\Delta(i-1/2)\omega) \cdot \sin(\Delta\omega/2))$$

On obtient :

$$\sigma(x) = \sum_{1}^{\infty} si \cdot e_i(x)$$

$$\Sigma(\omega) = \sum_{1}^{\infty} si \cdot E_i(\omega)$$

$$\Sigma(\omega) = \sum_{1}^{\infty} \left[ (2/\Delta) \times \int_{-\infty}^{+\infty} S(\omega) \cdot \cos((i+1/2)\omega\Delta) \cdot \sin(\omega\Delta/2)) d\omega / \omega \right] \cdot \left[ (4/\omega)(\sin(\Delta(i-1/2)\omega) \cdot \cos(\Delta\omega/2)) \right]$$

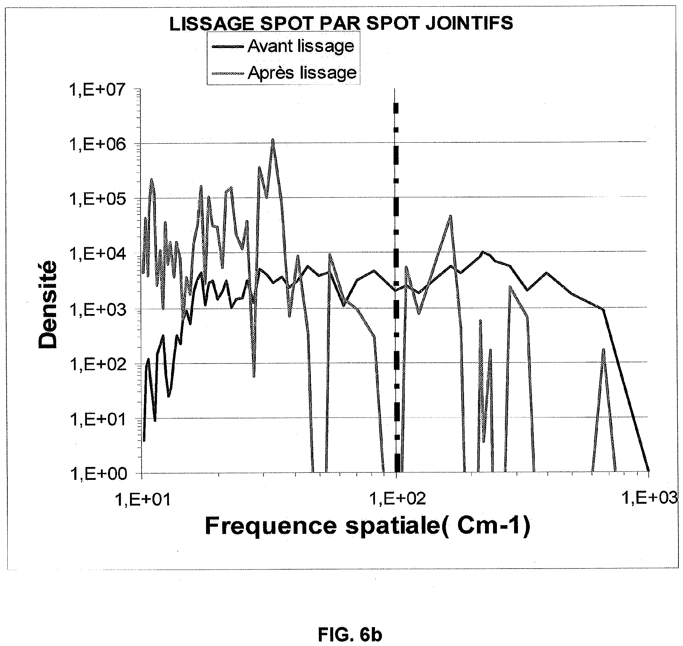

La figure 6b représente les densités spectrales de fréquences de rugosité observées à la surface d'une plaque, sans traitement et avec un traitement fractionné, à partir d'un spectre quelconque de rugosité initial.

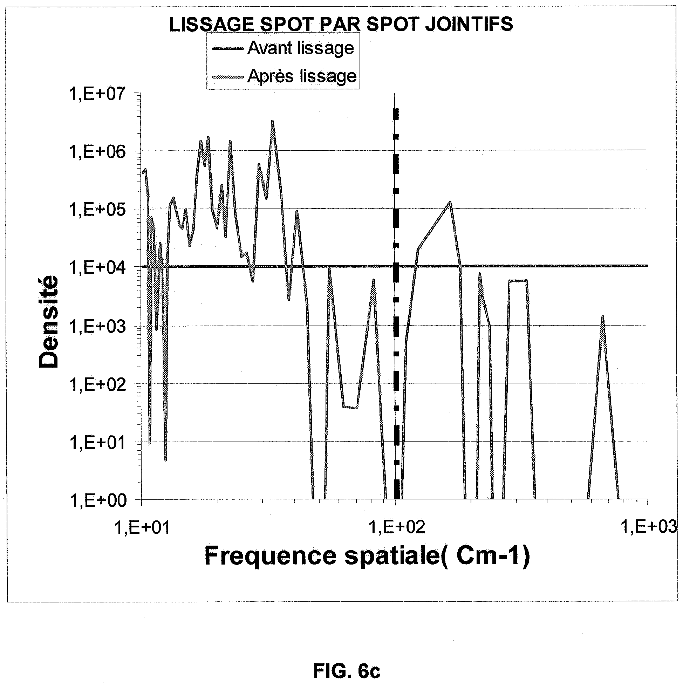

La figure 6c représente les densités spectrales de fréquences de rugosité observées à la surface d'une plaque, sans traitement et avec un traitement fractionné, à partir d'un spectre blanc de rugosité initial.

On voit que l'effet du lissage spot par spot sur la densité spectrale de rugosité est sensiblement moins efficace que dans le cas d'un traitement continu :

- En ce qui concerne les fréquences supérieures à la fréquence de coupure, il atténue très fortement place par place les fréquences existantes,

  - mais il laisse apparaître de nombreux pics de forte intensité

- En ce qui concerne les fréquences inférieures à la fréquence de coupure,

  - Il ne permet pas d'éliminer totalement les fréquences existantes
  - il en génère en outre d'autres, de grande amplitude.

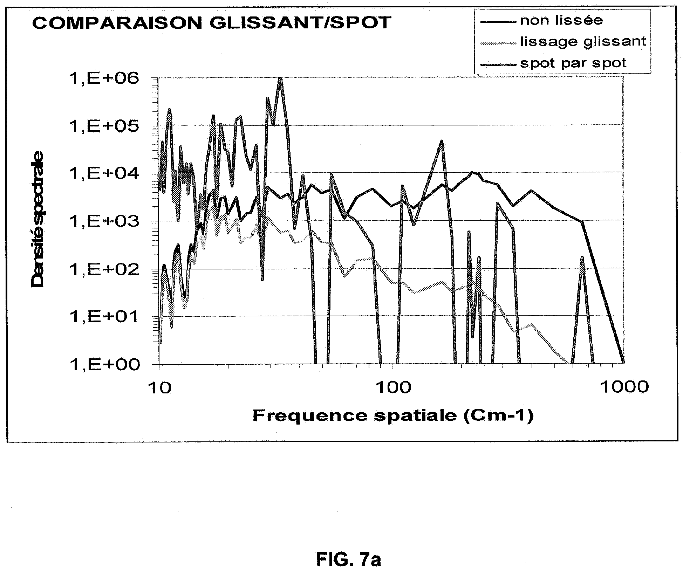

La figure 7a représente les densités spectrales de fréquences de rugosité observées à la surface d'une plaque, sans traitement, avec un traitement continu et avec un traitement fractionné, à partir d'un spectre quelconque de rugosité initial.

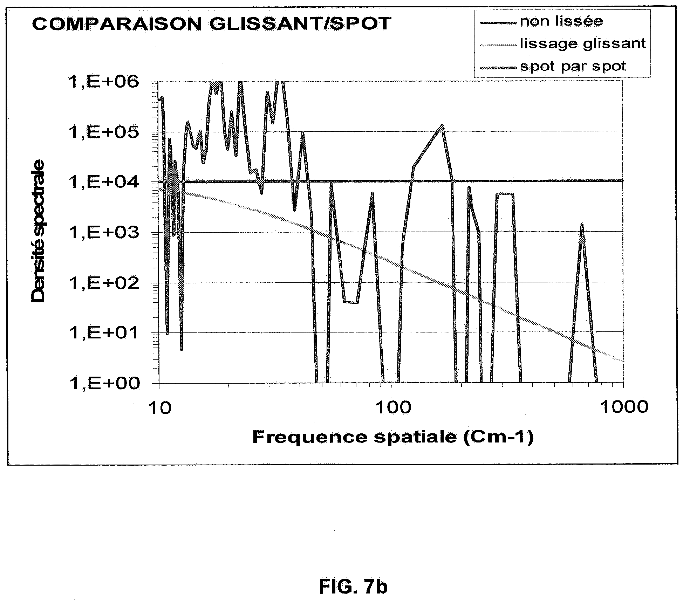

La figure 7b représente les densités spectrales de fréquences de rugosité observées à la surface d'une plaque, sans traitement, avec un traitement continu et avec un traitement fractionné, à partir d'un spectre blanc de rugosité initial.

Ces deux figures confirment les performances supérieures du traitement continu.

A titre d'exemple illustratif et non limitatif un exemple numérique est donné ci-après.

Soit Q (J.m$^{-3}$) la densité d'énergie volumique nécessaire pour atteindre la fusion.

Soit $\tau$ (s) le temps nécessaire au front de recristallisation pour atteindre la surface.

Soit $\Delta T$ (s) le temps de séjour du faisceau en un point.

Soit F (W.m$^{-2}$) la densité surfacique de puissance du faisceau.

Soit Ep (m) la profondeur maximum fondue.

Soit lp (m) la dimension du faisceau dans la direction du balayage.

Soit $v$ (m.s$^{-1}$) la vitesse de déplacement du faisceau.

Soit L (m) la longueur non recristallisée après le passage du faisceau.

Ordres de grandeurs relationnels :

$$Ep = F * \Delta T / Q = F * lp / (Q * v)$$

$$L = \tau * v$$

Exemple numérique :

$$F = 7MW \cdot cm^{-2}$$

$$Q = 7000J \cdot cm^{-3}$$

$$\Delta T = 1 \cdot 10^{-7} s$$

$$lp = 0,01cm = 100\mu m$$

$$v = 1000 \, m \cdot s^{-1}$$

$$\tau = 1 \cdot 10^{-6} s = 1\mu s$$

$$- - - - - - - - - - - - - - - - - - -$$

$$L = 10^3 \times 10^{-6} = 1 \cdot 10^{-3} \, m = 1000\mu m$$

$$Ep = 7 \cdot 10^6 \times 10^{-7} / 7000 = 1 \cdot 10^{-4} \, cm = 1\mu m$$

**Revendications**

1. Procédé de lissage de la surface d'une plaque semiconductrice, comprenant la mise en fusion de ladite surface par balayage de ladite surface par un faisceau de fusion (F), **caractérisé en ce qu'**il comprend :

   - La définition d'une longueur de référence,
   - Le réglage des paramètres du faisceau de fusion de manière à fusionner, lors du balayage de la surface, une zone locale de surface de la plaque dont la longueur (L) est supérieure ou égale à la longueur de référence,
   - La fusion ainsi réalisée permettant de lisser ladite surface de manière à éliminer les rugosités de surface de période inférieures à la longueur de référence.

2. Procédé selon la revendication précédente **caractérisé en ce que** la définition de la longueur de référence fait suite à une observation de la distribution de rugosité de la surface de la plaque et à l'identification d'une fréquence de coupure issue de la distribution des fréquences de rugosité observées à la surface de la plaque.

3. Procédé selon la revendication 1 **caractérisé en ce que** la définition de la longueur de référence fait suite à la détermination d'une dimension de référence représentative de dispositifs devant être constitués dans une région de surface de la plaque, la longueur de référence étant supérieure ou égale à la dimension de référence.

4. Procédé selon l'une des revendications précédentes **caractérisé en ce que** la mise en fusion comprend la fusion de la zone locale de la plaque et le faisceau de fusion est un faisceau énergétique apte à faire fondre une région de surface de la plaque.

5. Procédé selon l'une des revendications précédentes **caractérisé en ce que** la mise en fusion comprend l'apport de matériau fondu sur ladite zone locale de la plaque et le faisceau de fusion est défini par la section du flux d'apport de matériau fondu à la surface de la plaque.

6. Procédé selon l'une des revendications précédentes **caractérisé en ce que** lesdits paramètres du faisceau de fusion comprennent la vitesse de déplacement du faisceau.

7. Procédé selon l'une des revendications précédentes prise en combinaison avec la revendication 4 **caractérisé en ce que** lesdits paramètres du faisceau de fusion comprennent la densité de puissance du faisceau.

8. Procédé selon l'une des trois revendications précédentes prise en combinaison avec la revendication 5 **caractérisé en ce que** lesdits paramètres du faisceau de fusion comprennent le débit du flux d'apport de matériau fondu.

**Patentansprüche**

1. Verfahren zum Glätten der Oberfläche eines Halbleiterwafers, umfassend das Einschmelzen der Oberfläche durch Scannen der Oberfläche mit einem Schmelzstrahl (F), **dadurch gekennzeichnet, dass** es umfasst:

- das Definieren einer Referenzlänge,
- das Einstellen der Parameter des Schmelzstrahls derart, dass beim Scannen der Oberfläche eine lokale Oberflächenzone des Wafers, deren Länge (L) größer oder gleich der Referenzlänge, schmilzt,
- wobei das derart durchgeführte Schmelzen erlaubt, die Oberfläche derart zu glätten, dass Oberflächenrauigkeiten mit kürzerer Periode als die Referenzlänge entfernt werden.

2. Verfahren nach vorangehendem Anspruch, **dadurch gekennzeichnet, dass** die Definition der Referenzlänge nach einer Beobachtung der Verteilung der Oberflächenrauigkeit des Wafers und nach der Identifizierung einer Grenzfrequenz, ausgehend von der Verteilung der auf der Oberfläche des Wafers beobachteten Rauigkeitsfrequenzen, erfolgt.

3. Verfahren nach Anspruch 1, **dadurch gekennzeichnet, dass** die Definition der Referenzlänge nach der Bestimmung einer repräsentativen Referenzgröße von Vorrichtungen erfolgt, die in einer Oberflächenregion des Wafers gebildet werden müssen, wobei die Referenzlänge größer oder gleich der Referenzgröße ist.

4. Verfahren nach einem der vorangehenden Ansprüche, **dadurch gekennzeichnet, dass** das Einschmelzen das Schmelzen der lokalen Zone des Wafers umfasst und der Schmelzstrahl ein Energiestrahl ist, der imstande ist, eine Oberflächenregion des Wafers zum Schmelzen zu bringen.

5. Verfahren nach einem der vorangehenden Ansprüche, **dadurch gekennzeichnet, dass** das Einschmelzen den Auftrag von geschmolzenem Material auf die lokale Zone des Wafers umfasst und der Schmelzstrahl durch Auswahl des Auftragsstroms geschmolzenen Materials auf der Oberfläche des Wafers definiert ist.

6. Verfahren nach einem der vorangehenden Ansprüche, **dadurch gekennzeichnet, dass** die Parameter des Schmelzstrahls die Verlagerungsgeschwindigkeit des Strahls umfassen.

7. Verfahren nach einem der vorangehenden Ansprüche, herangezogen in Kombination mit Anspruch 4, **dadurch gekennzeichnet, dass** die Parameter des Schmelzstrahls die Leistungsdichte des Strahls umfassen.

8. Verfahren nach einem der drei vorangehenden Ansprüche, herangezogen in Kombination mit Anspruch 5, **dadurch gekennzeichnet, dass** die Parameter des Schmelzstrahls den Durchsatz des Auftragsstroms geschmolzenen Materials umfassen.

**Claims**

1. A process for smoothing the surface of a semiconductor wafer, comprising fusing of said surface by scanning said surface with a fusion beam (F), **characterized in that** it comprises:

- The definition of a reference length,
- The adjustment of the parameters of the fusion beam so as to fuse, during the scanning of the surface, a local surface zone of the wafer whose length (L) is greater than or equal to the reference length,
- The fusion is thus carried out to smooth said surface so as to eliminate the surface roughnesses of period lower than the reference length.

2. The process according to the preceding claim, **characterized in that** the reference length is defined by observing roughness distribution on the surface of the wafer and identifying a cutoff frequency arising from the distribution of the roughness frequencies observed on the surface of the wafer.

3. The process according to claim 1, **characterized in that** the reference length is defined by determining a reference dimension representative of devices requiring to be constructed in a surface region of the wafer, with the reference length being greater than or equal to the reference dimension.

4. The process according to one of the preceding claims, **characterized in that** the fusing comprises the melting of the local zone of the wafer and the fusion beam is an energetic beam able to melt a surface region of the wafer.

5. The process according to one of the preceding claims, **characterized in that** the fusing comprises the feeding of molten material onto said local zone of the wafer with the fusion beam defined by the cross section of the feed stream of molten material on the surface of the wafer.

6. The process according to one of the preceding claims, **characterized in that** said parameters of the fusion beam comprise the speed of movement of the beam.

7. The process according to one of the preceding claims taken in combination with claim 4, **characterized in that** said parameters of the fusion beam comprise the power density of the beam.

8. The process according to one of the three preceding claims taken in combination with claim 5, **characterized in that** said parameters of the fusion beam comprise the flowrate of the feed stream of molten material.

FIG. 1

FIG. 2a

FIG. 2b

**FIG. 3**

**FIG. 4a**

Flux de silicium liquide

**FIG. 4b**

**FIG. 5a**

FIG. 5b

FIG. 5c

**FIG. 5d**

**MOYENNE GLISSANTE AVEC LISSAGE**

non lissée — lissée une fois — lissée 2 fois

FIG. 5e

FIG. 6a

FIG. 6b

**FIG. 6c**

**FIG. 7a**

**FIG. 7b**

**EP 2 485 249 B1**

## RÉFÉRENCES CITÉES DANS LA DESCRIPTION

**Documents brevets cités dans la description**

- WO 2007142911 A